# EUROPEAN PATENT APPLICATION

(11) **EP 1 427 001 A1**
(43) Date of publication of application: **09.06.2004**
(21) Application number: 02293043.2
(22) Date of filing: 06.12.2002
(51) Int. Cl.: H01L 21/304, H01L 21/306

(54) **A method for recycling a surface of a substrate using local thinning**

(71) Applicant: S.O.I. Tec Silicon on Insulator Technologies S.A., 38190 Bernin (FR)
(72) Inventor: Letertre, Fabrice, 38000 Grenoble (FR); Maurice, Thibaut, 38100 Grenoble (FR); Mazure, Carlos, 38330 Grenoble (FR)
(74) Representative: Grünecker, Kinkeldey, Stockmair & Schwanhäusser Anwaltssozietät

(57) **Abstract**

The present invention relates to a method for recycling a surface of a substrate, especially a silicon wafer, wherein the surface comprises a separation profile which has been formed by a separation step and said separation step has been carried out after an implantation of a substance into the substrate, wherein said separation profile is planarised by removing material from the surface for obtaining a plane uniform surface. It is the object of the present invention to provide a method for recycling of a surface of a substrate by which the recycled surface can be more often reused and wherein the recycled substrate has a good thickness variance. This object is solved by a method of the above-mentioned type characterised in that only the region of said surface being close to the edge of said substrate is planarised by a successive thinning of the material of said region in a separate step.

## Description

The present invention relates to a method for recycling a surface of a substrate, especially a semiconductor wafer, wherein the surface comprises a separation profile which has been formed by a separation step and said separation step has been carried out after an implantation of a substance into the substrate, wherein said separation profile is planarised by removing material from the surface for obtaining a plane uniform surface.

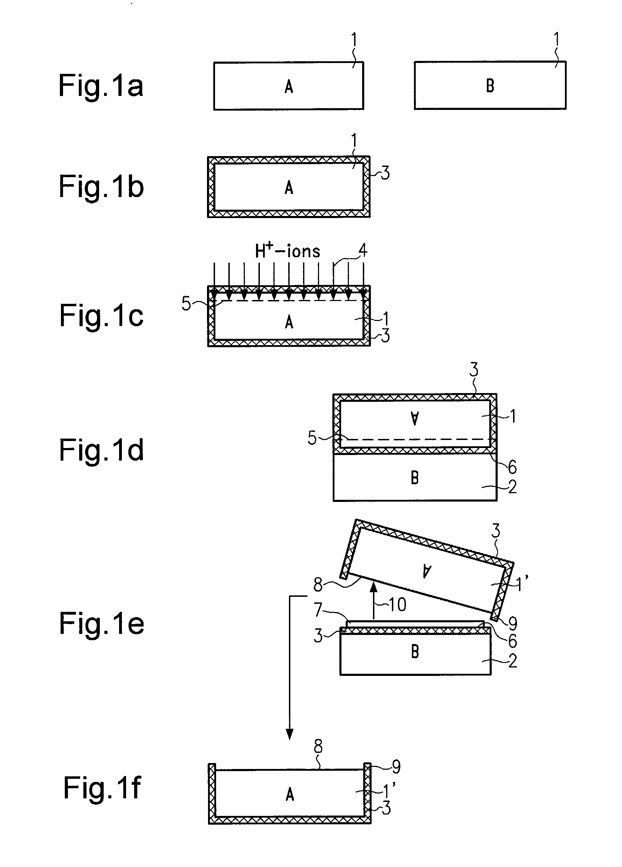

Recycling or reprocessing of substrates, especially of semiconductor wafers in semiconductor technology, offers the opportunity to save a lot of money in new material costs. Wafer recycling can, for instance, be used in the so-called Smart-cut® process which principle is shown in Fig. 1. In this process, for instance a first silicon wafer 1 which is oxidised and implanted with gaseous species like hydrogen or gas ions 4. The implantation leads to the creation of a buried, weakened layer comprising microcavities, platelets and/or microbubbles. The implanted wafer is bonded with a second silicon wafer 2 and then separated by splitting in a depth of the wafer corresponding to the penetration depth 5 of the implanted species. In this way, a SOI (silicon on insulator) wafer B is produced. In this technology, a negative or delaminated wafer 1' is produced as a by-product. The just delaminated wafer 1' cannot be reused directly because it comprises a collar 9 in form of a step in the peripheral part of the wafer 1', a damage layer on its surface 8 and a high surface roughness.

The collar 9 which can extend all around the edge of the delaminated wafer 1' is formed in the Smart-cut® process where during bonding, the surfaces of both wafer 1,2 are bonded except an edge exclusion where the wafers are not flat. That part of the surface of the first wafer 1 which is bonded with the second wafer 2 is transferred on the second wafer 2 during splitting. The edge exclusion which is not bonded is not transferred and forms the collar 9 of the delaminated wafer 1' and a loss of material at the edge of the positive wafer containing the original wafer 2 and a SOI-layer 7 split from the first wafer 1.

For reusing of the delaminated wafer 1', a chemical mechanical polishing (CMP) is conventionally used removing material from an uneven topography on the wafer surface to obtain a uniform planarisation globally across the wafer. This is done by applying a load force to the entire surface 8 including its collar 9 of the wafer 1' while it rests on a pad (not shown). Both the pad and the wafer are then counter-rotated while a slurry containing both abrasives and reactive chemicals is passed underneath.

In this recycling method, too much material has to be removed from the wafer and a long processing time is necessary to get a reasonably acceptable value of the total thickness variation (TTV) of the recycled delaminated wafer. Therefore, the recoverability of the wafer is strongly limited. Furthermore, there exists a risk of breaking of the wafer during its planarisation, especially when the wafer is reclaimed repeatedly.

EP 0 955 671 A1 describes a method for recycling a delaminated wafer of the above mentioned type in which the delaminated wafer surface is polished to remove about 1 µm material from the surface and is then heat treated in a reducing atmosphere at a temperature between 1000°C and the melting point of the wafer material for several hours. This thermal treatment represents a strong load on the treated wafer and spends a lot of energy and processing time.

It is the object of the present invention to provide an improved method of the above-mentioned type which allows a recycled wafer to be reused more often and enables the recycled wafer to be produced with a low total thickness variance wherein a good planar surface quality is obtained.

This object is solved with a method of the above-mentioned type characterised in that only the region of said surface being close to the edge of said substrate is planarised by a successive thinning of the material of said region in a separate step.

Using the inventive method, only by the thinning of material in the region of the surface being close to the edge of the substrate, a smoothness of the surface can be achieved.
The thinning step allows a continuous attack and removal of a surface inhomogeneity at this region close to the edge from above or from sidewards so that the removed material is precisely controllable. Because of the removal of material restricted to that region close to the edge of the substrate only a small amount of material is removed. Therefore, the substrate can be more often reused and recycled. In addition, a low total thickness variation of the recycled substrate can be achieved. Due to the reduced material removal, the recycled substrate is thicker and therefore more stable so that the risk of breaking the substrate during recycled can be reduced.

In an embodiment of the invention, said separate step comprises a local polishing at the edge of the substrate. Polishing enables an effective successive removal of material.

In a further embodiment of the invention, a mechanical pressure is applied on the edge of the substrate, wherein the pressure is directed in an angle relative to the surface of the substrate. The mechanical pressure advances the material removal from the surface at the edge of the substrate. The special direction of the applied pressure facilitates pushing aside of the removed material.

In a favourable variant of the present invention, the removal of the material from the surface is controlled by a mechanical profilometer. This measuring instrument provides a precise measurement of the removed material.

According to a further favourable embodiment of the invention, said separate step comprises a selective chemical attack at the edge of the substrate. By this method only the edge of the substrate is treated whereas the other part of the surface of the substrate is not attacked. A chemical attack offers an efficient abrasion of material.

In a further example of the invention, a region on the surface surrounded by the region close to the edge is covered by a protective layer. This layer protects this region between the edges from influences due to removal of material close to the edge.

In a further advantageous embodiment, said protective layer is an etch resistant material. The etch resistant material particularly protects the surface between the edge from etching by a physical and/or a chemical etchant.

In a further favourable variant of the invention, the protective layer is formed by a photolithography. The contour of the protective layer can be defined by photolithography. This offers the possibility to deposit and/or harden the protective layer especially in the region of the surface between the edges with a high precision.

According to a favourable embodiment of the invention, the separate step comprises a local ion attack at the edge of the substrate, preferably by ion clusters. An ion attack can be precisely localised at the edge of the substrate and removes material in an effective way.

In a further advantageous embodiment of the invention, the ion attack is made by an ion beam being directed approximately perpendicular to the surface of the substrate. The ion beam can be nearly exactly directed to the material which should be removed from the surface. The approximately perpendicular direction of the ion beam allows a selective and effective abrasion of the material.

In a further advantageous example of the invention, the ion attack is made by an Argon ion beam directed on the region being close to the edge of the substrate. The Argon ions can be easily accelerated and directed onto this region which facilitates the removal of the material at this region.

In a further advantageous embodiment of the invention, the substrate rotates during the thinning step. By this method, the thinning step must only be applied on one point or one region at the edge of the surface. Then, by the rotation of the substrate, the entire edge around the substrate can be treated by the thinning step.

According to a further advantageous variant of the invention, the entire surface including the edge region is planarised after said separate step. By this further planarisation, the whole surface can be finally planarised to get, especially, a very smooth transitional region between the region close to the edge and the other parts of the surface of the substrate.

In another favourable example of the invention, the surface including the edge is thinned in the planarising step by about 0.2 µm. In this manner, a damaged area of the substrate resulting from an implantation step can be removed.

In a yet further preferable embodiment of the invention, said substrate is planarised without a heat treatment. By this method, the thermal load on the substrate is very low. Furthermore, long processing times and a high energy consumption for a thermal treatment are avoided.

Embodiments of the present invention are described in the following description with reference to the accompanying figures, in which
- Fig. 1: shows a conventional Smart-cut® process;
- Fig. 2: shows a local polishing at an edge of a wafer according to a first embodiment of the present invention;
- Fig. 3: shows a selective chemical attack at an edge of a wafer according to a second embodiment of the present invention; and
- Fig. 4: shows a local ion attack at an edge of a wafer according to a third embodiment of the present invention.

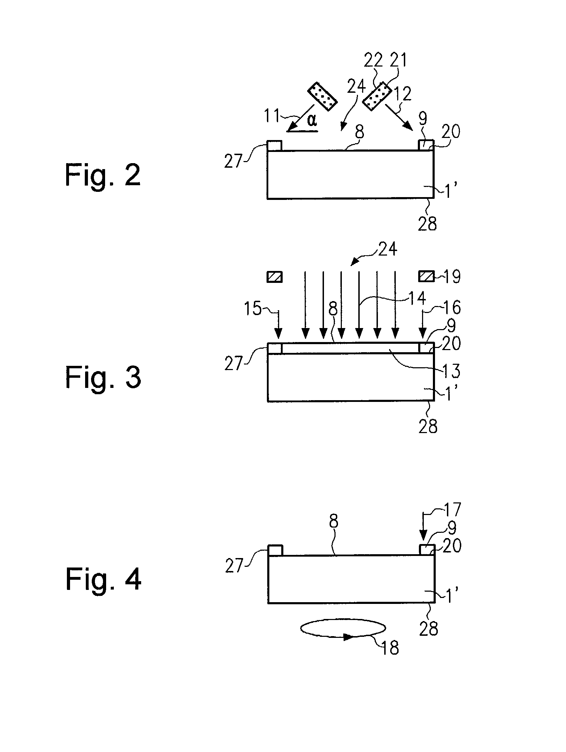

Figs. 2 to 4 show a silicon wafer 1' comparable with the wafer 1' shown in Fig. 1 which is produced by the Smart-cut® technology. The silicon wafer 1' has a collar 9 close to an edge 27 of the wafer 1' consisting of silicon and/or silicon dioxide around its surface 8. Instead of a silicon wafer and a collar consisting of silicon or silicon dioxide, all materials available in semiconductor technology can be recycled with the method of the present invention. Typical materials are silicon in all modifications such as CZ-silicon, NPC-silicon, Epi-Silicon, FZ-silicon, silicon carbide (SiC), A_{III}B_{V}-compounds such as Galliumarsenide (GaAs), Galliumnitride (GaN), Indiumphosphide (InP) and their alloys or Silicon Germanium (SiGe) and their oxides. The materials can be doped or undoped, semi-insulator materials or Epi-materials. Further, the treated substrates are not restricted to be wafers. The substrate can have any form or size available in semiconductor technology.

It is further not necessary that the wafers or substrates are pre-processed using the Smartcut® technology as shown with reference to Fig. 1. Further to this, all substrates having at least a non-uniformity on their surface can be recycled with the method of the present invention.

The collar of the embodiment has a width between about 1 and 5 millimetres and a thickness between approximately 10 nanometers and about 2 micrometers. The collar 9 is treated with hydrogen ions in the implantation step of the Smart-cut® technology shown in Fig. 1c). Between the surface 8 and the collar 9 is an interface 20 on a level corresponding to a direct prolongation of the separation line 5 shown in Fig. 1. The interface has a weakened material stability due to the implantation.

The collar 9 as well as the surface 8 can be covered by a thin oxide film which can be removed prior to planarising the wafer 1'.

Fig. 2 shows a local polishing at an edge of a wafer, according to a first embodiment of the present invention. As shown by the arrows 11 and 12 in Fig. 2, a chemical and/or mechanical component (21,22) is directed in an angle relative to the surface 8 to polish only the collar 9. The chemical/mechanical polishing is performed in this first embodiment with a polishing pad such as a polyurethane pad with colloidal silica. Instead of the shown directions 11, 12, all directions of attack can be chosen for chemical/mechanical polishing which are directed to the collar 9 or to the interface 20. Although not shown, in a further embodiment of the invention the wafer can be rotated during chemical/mechanical polishing.

The material removal of the collar is controlled by a mechanical profilometer (not shown). The removal is finished when the values determined by the mechanical profilometer show that the collar 9 is removed from the surface 8 resulting in the same surface level in the region close to the edge 27 and the rest of the surface 8.

After the removal of the collar follows a short final touch polishing of the surface 8 with a conventional CMP process on the entire surface 8 including its edges. In this step about 0.2 µm of material is removed at the maximum which amount corresponds approximately to the upper limit of the damaged area due to the implantation step used in the Smart Cut® technology for fabricating of the split wafer 1'. This polish eliminates defects resulting from the implantation step shown in Fig. 1 and provides a good TTV of the polished surface 8.

Fig. 3 shows a second embodiment of the present invention in which the collar 9 at the edge of the surface 8 of the wafer is removed by a selective chemical attack of the surface region close to the edge 27 of the wafer 1'. The region on the surface 8 between the collar 9 is protected in a photolithography step, wherein a photo resist layer 13 is deposited on the wafer 1' and exposed to a light beam through a mask 19 wherein the mask 19 covers the region close to the edge 27 of the wafer 1'. For this method, a positive as well as a negative photoresist can be used. Moreover, instead of the photo resist, any other layer can be deposited or filled in the room between the collar and the surface 8 which is able to protect the surface for a certain period of time during removal of the collar and which is removable from the surface. Furthermore, the mask dimensions can be adapted to the size of the collar 9 at the edge of the surface 8.

After this photolithography step, only the surface 8 between the collar 9 is protected by the hardened photo resist 13.

In a further step, the wafer 1' is exposed to a chemical substance such as KOH, TMAH, NH₄OH or NaOH, which acts at least on the points of attack shown by the arrows 15,16, on the collar 9. The chemical substance reacts with the material of the collar and removes it. During chemical attack, the wafer 1' can be rotated.

The removal of the collar 9 is controlled by the used etch time and etch temperature and can further be controlled after etching with the mechanical profilometer described above with reference to Fig. 2. The protecting layer 13 can be removed from the surface 8 in a separate step but also together with a final polishing step on this surface. The surface is further treated with a final polishing similar to that of the first embodiment.

Fig. 4 shows a third embodiment of the method of the present invention in which the collar 9 of the wafer 1' is removed by a local ion attack. An ion beam, consisting of Argon ions in this embodiment, is directed approximately perpendicular to the surface 8 onto the collar 9 as shown by the arrow 17 in Fig. 4. Instead of Argon ions, clusters of Argon ions can be used for local ion etching. For directing the ion beam 17 on the collar 9, for instance, a gas cluster ion beam (GCIB) technique developed by the EPION Corporation, Billerica MA, can be used. Instead of this technique, also a conventional ion beam implanter can be used.

During ion attack, the wafer 1' is rotated as shown by the arrow 18 in Fig. 4. In this way, the ion beam 17 can act on the entire edge of the wafer 1' and removes continuously the collar by the impact of the Argon ions with the material of the collar 9.

In the following, the function of the embodiments of the present invention shown in the Figs. 2 to 4 are described.

In order to planarise the surface 8 of the wafer 1' in the surface region close to the edge 27 of the wafer 1', according to a first embodiment of the invention shown in Fig. 2, the surface is locally polished at the edge of the wafer 1'. One or more polishing pads 21 are directed at an angle alpha relative to the surface 8 and apply a mechanical pressure on the collar 9 of the wafer 1. The polishing pad is impregnated with a polishing slurry 22 which contains chemical components such KOH and which react with the material of the collar 9 and the edge successively with the help of the mechanical pressure with the collar 9. After a certain period of time, the difference between the wafer thickness at the edge 27 of the wafer 1' and at a point of the interior of the wafer 1' is evaluated. The process is finished when this difference is near or equal to a predetermined value close to zero. Then, the whole surface 8 is finally polished with a conventional short CMP process.

With reference to Fig. 3, the region of the surface 8 being close to the edge 27 of the wafer 1' is thinned successively by a selective chemical attack at the edge 27 of the wafer 1'. In this method, a photoresist layer 13 is deposited on the surface 8 including in the region close to the edge 27. Then, a mask layer 19 is provided over the wafer 1'. In a further step, a light or an electronic beam 14 is lit through the mask 19 to the surface 8 of the wafer 1'. In this step, only the surface region between the collar 9 is exposed to the light or the ion beam 14. Then, the mask 19 is removed and the photoresist 13 is developed in a further step, the non-exposed regions of the photoresist 13 are removed by etching so that only a hardened photoresist layer 13 remains on the region of the surface 8 between the collar 9. Thereafter, the collar 9 is etched for instance with KOH. In this etch process, the etch time and the etch temperature are controlled. After a certain etch time, the thickness of the wafer 1' at the region near the edge 27 is compared with the thickness of the wafer 1' in an interior 24 of the wafer 1'. If the difference is below a predetermined value, the etch process can be stopped and the wafer surface can be cleaned from the photoresist layer 13. Further, the whole surface 8 is finally polished with a CMP process similar to that of the first embodiment.

With reference to Fig. 4, the third embodiment of the method of the present invention is shown in which the region of the surface 8 close to the edge 27 of the wafer 1' is planarised by a successive thinning using a local ion attack at the edge 27 of the wafer 1'. In this method, an Argon ion beam 17 is directed onto the collar 9 of the wafer 1. Furthermore, the wafer 1' is rotated, so that the ion beam 17 can cover the whole collar 9 surrounding the surface 8 of the wafer 1' during implantation. The ions bombard the collar 9 from above and continuously thin the collar 9 down to the level of the surface 8. As described with reference to Fig. 2 and 3, the abrasion of the collar 9 can be controlled with a mechanical profilometer measuring the thickness difference between a region of the wafer near the edge 27 and a region in the interior 24 of the wafer 1'.

## Claims

1. A method for recycling a surface (8) of a substrate (1'), especially a silicon wafer, wherein the surface (8) comprises a separation profile which has been formed by a separation step and said separation step has been carried out after an implantation of a substance into the substrate, wherein said separation profile is planarised by removing material from the surface (8) for obtaining a plane uniform surface,
**characterised in that** only the region of said surface (8) being close to the edge (27) of said substrate (1') is planarised by a successive thinning of the material of said region in a separate step.

2. The method according to claim 1, **characterised in that** said separate step comprises a local polishing at the edge of the substrate (1').

3. The method according to at least one of the claims 1 or 2, **characterised in that** a mechanical pressure is applied on the edge (27) of the substrate (1'), wherein the pressure is directed in an angle relative to the surface (8) of the substrate (1').

4. The method according to at least one of the preceding claims, **characterised in that** the removing of the material from the surface (8) is controlled by a mechanical profilometer.

5. The method according to at least one of the preceding claims, **characterised in that** said separate step comprises a selective chemical attack at the edge (27) of the substrate (1').

6. The method according to at least one of the preceding claims **characterised in that** a region on the surface (8) surrounded by the region close to the edge (27) is covered by a protective layer (13).

7. The method according to claim 6, **characterised in that** said protective layer (13) is an etch resistant material.

8. The method according to at least one of the claims 6 or 7, **characterised in that** the protective layer (13) is formed by a photolithography.

9. The method according to at least one of the preceding claims, **characterised in that** the separate step comprises a local ion attack at the edge (27) of the substrate (1'), preferably by clusters.

10. The method according to claim 9, **characterised in that** the ion attack is made by an ion beam being directed approximately perpendicular to the surface (8) of the substrate (1').

11. The method according to at least one of the claims 9 or 10, **characterised in that** the ion attack is made by an Argon ion beam (17) directed on the region being close to the edge (27) of the substrate (1').

12. The method according to at least one of the preceding claims, **characterised in that** the substrate (1') rotates during the thinning step.

13. The method according to at least one of the preceding claims, **characterised in that** the entire surface (8) including the edge (27) region is planarised after said separate step.

14. The method according to claim 13, **characterised in that** the surface (8) including the edge (27) is thinned in the planarising step by about 0.2 µm.

15. The method according to at least one of the preceding claims, **characterised in that** said substrate (1') is planarised without a heat treatment.
